# EUROPÄISCHE PATENTANMELDUNG

(11) **EP 4 775 999 A1**
(43) Veröffentlichungstag der Anmeldung: **15.07.2026**
(21) Anmeldenummer: 25151191.1
(22) Anmeldetag: 10.01.2025
(51) Int. Cl.: G01R 22/06, H02B 1/03

(54) **BAUGRUPPE ZUR MONTAGE EINES ZUSATZGERÄTS AN EINEM ELEKTRIZITÄTSZÄHLER**

(71) Anmelder: EMH metering GmbH & Co. KG, 19258 Gallin (DE)
(72) Erfinder: Glomski, Marek, 21035 Hamburg (DE)
(74) Vertreter: Hauck Patent- und Rechtsanwälte PartmbB

(57) **Zusammenfassung**

Baugruppe zur Montage eines Zusatzgeräts an einem Elektrizitätszähler, wobei der Elektrizitätszähler eine Rückseite, eine Vorderseite und mehrere Anschlussklemmen aufweist, die an einer Unterseite des Elektrizitätszählers in einer Reihe entlang einer Breitenrichtung des Elektrizitätszählers angeordnet sind, wobei die Baugruppe folgendes aufweist:
• ein Haltebauteil, das zwei Befestigungsabschnitte zur Befestigung an dem Elektrizitätszähler und eine Tragschiene aufweist, an der ein Zusatzgerät befestigt werden kann,
• wobei, wenn das Haltebauteil an dem Elektrizitätszähler befestigt ist, die Tragschiene in der Breitenrichtung des Elektrizitätszählers verläuft und in einem Abstand von den Anschlussklemmen angeordnet ist, sodass die Anschlussklemmen zugänglich sind, und
• eine Abdeckung zur Befestigung an dem Haltebauteil und/oder an dem Elektrizitätszähler, wobei die Abdeckung die Tragschiene und die Anschlussklemmen und mindestens teilweise ein an der Tragschiene angeordnetes Zusatzgerät abdeckt, wenn die Abdeckung an dem Haltebauteil und/oder an dem Elektrizitätszähler befestigt ist.

## Beschreibung

Die Erfindung betrifft eine Baugruppe zur Montage eines Zusatzgeräts an einem Elektrizitätszähler, der eine Rückseite, eine Vorderseite und mehrere Anschlussklemmen aufweist, die an einer Unterseite des Elektrizitätszählers in einer Reihe entlang einer Breitenrichtung des Elektrizitätszählers angeordnet sind.

Elektrizitätszähler sind Messgeräte zur Erfassung eines elektrischen Energieverbrauchs, insbesondere zu Abrechnungszwecken. Über diese Grundaufgabe hinaus können Elektrizitätszähler zunehmend weitere Aufgaben erfüllen, zum Beispiel eine Netzqualität überwachen oder elektrische Verbraucher und Energieerzeuger steuern. Hierfür sind Zusatzgeräte erforderlich, beispielsweise Smart Meter Gateways, Funkeinrichtungen, Steuer- und Schalteinrichtungen. Diese Zusatzgeräte können entweder am Elektrizitätszähler selbst oder benachbart dazu in einem Zählerschrank montiert und mit dem Elektrizitätszähler verbunden werden. Zur Montage der Zusatzgeräte sind unterschiedliche Lösungen bekannt geworden.

Die elektronischen Basiszähler für Dreipunktbefestigung vom Typ "eBZD Generation H" aus dem Hause der Anmelderin haben eine Rückseite, eine Vorderseite und mehrere Anschlussklemmen, die an einer Unterseite des Elektrizitätszählers in einer Reihe entlang einer Breitenrichtung des Elektrizitätszählers angeordnet sind. Die Anschlussklemmen werden mit einem Klemmendeckel abgedeckt. An der Vorderseite des Elektrizitätszählers, oberhalb des Klemmendeckels, ist eine Hutschiene angeordnet, an der Zusatzgeräte befestigt werden können. Diese werden mit einem gesonderten Moduldeckel abgedeckt.

Aus der Druckschrift DE 10 2009 022 645 B4 ist ein Elektrizitätszähler mit einem Klemmendeckel bekannt geworden, auf dem eine kurze, vertikal verlaufende Hutschiene angeordnet ist. Ein an dieser Hutschiene befestigtes Zusatzgerät wird von einer gesonderten Abdeckung abgedeckt.

Aus der Druckschrift DE 10 2020 122 869 A1 ist ein Elektrizitätszähler mit einem Sicherungshalter bekannt geworden, der in eine Öffnung eines Gehäuses des Elektrizitätszählers einsetzbar ist.

Aus der Druckschrift EP 3 521 835 B 1 ist ein Elektrizitätszähler mit Anschlussklemmen und einem die Anschlussklemmen abdeckenden Klemmendeckel bekannt geworden, der mittels einer Rastverbindung an einem Gehäuse des Elektrizitätszählers befestigt wird.

Davon ausgehend ist es die Aufgabe der Erfindung, eine Baugruppe zur Montage eines Zusatzgeräts an einem Elektrizitätszähler, der eine Rückseite, eine Vorderseite und mehrere Anschlussklemmen aufweist, die an einer Unterseite des Elektrizitätszählers in einer Reihe entlang einer Breitenrichtung des Elektrizitätszählers angeordnet sind, zur Verfügung zu stellen, mit der unterschiedliche Zusatzgeräte bei verbesserter Ausnutzung des engen Bauraums besonders einfach und flexibel montiert werden können.

Diese Aufgabe wird gelöst durch die Baugruppe mit den Merkmalen des Anspruchs 1. Vorteilhafte Ausgestaltungen sind in den Unteransprüchen angegeben.

Die Baugruppe dient zur Montage eines Zusatzgeräts an einem Elektrizitätszähler, wobei der Elektrizitätszähler eine Rückseite, eine Vorderseite und mehrere Anschlussklemmen aufweist, die an einer Unterseite des Elektrizitätszählers in einer Reihe entlang einer Breitenrichtung des Elektrizitätszählers angeordnet sind, wobei die Baugruppe folgendes umfasst:
- ein Haltebauteil, das zwei Befestigungsabschnitte zur Befestigung an dem Elektrizitätszähler und eine Tragschiene aufweist, an der ein Zusatzgerät befestigt werden kann,
- wobei, wenn das Haltebauteil an dem Elektrizitätszähler befestigt ist, die Tragschiene in der Breitenrichtung des Elektrizitätszählers verläuft und in einem Abstand von den Anschlussklemmen angeordnet ist, sodass die Anschlussklemmen zugänglich sind, und
- eine Abdeckung zur Befestigung an dem Haltebauteil und/oder an dem Elektrizitätszähler, wobei die Abdeckung die Tragschiene und die Anschlussklemmen und mindestens teilweise ein an der Tragschiene angeordnetes Zusatzgerät abdeckt, wenn die Abdeckung an dem Haltebauteil und/oder an dem Elektrizitätszähler befestigt ist.

Die Rückseite des Elektrizitätszählers ist bei installiertem Elektrizitätszähler an einer Wand angeordnet, an der der Elektrizitätszähler befestigt ist, insbesondere in einem Zählerschrank. Die Vorderseite ist einem Benutzer zugewandt, sie kann ein Display und/oder ein Bedienelement und/oder eine Datenschnittstelle aufweisen. Die Unterseite weist nach unten. An der Unterseite sind die Anschlussklemmen angeordnet, die bei Installation des Elektrizitätszählers mit einem Versorgungsnetz und einem verbraucher-/erzeugerseitigen Netz verbunden werden.

Soweit nachfolgend Richtungsangaben wie horizontal/vertikal, vorn/hinten, oben/unten, rechts/links verwendet werden, beziehen sie sich auf den installierten, wie beschrieben mit der Rückseite an einer Wand angeordneten Elektrizitätszählers bzw. auf einen davorstehenden Benutzer. Im Betrieb erfasst der Elektrizitätszähler insbesondere Energiemengen, die von dem Versorgungsnetz in das verbraucher-/erzeugerseitige Netz fließen und/oder umgekehrt.

Die Unterseite des Elektrizitätszählers hat eine Breite, die sich von einer linken Seitenwand zu einer rechten Seitenwand des Elektrizitätszählers erstrecken kann. Der Elektrizitätszähler weist ein Gehäuse auf, das an der Vorderseite des Elektrizitätszählers eine Vorderwand, an der Rückseite des Elektrizitätszählers eine Rückwand, an einer linken Seite des Elektrizitätszählers eine linke Seitenwand und an der rechten Seite des Elektrizitätszählers eine rechte Seitenwand aufweisen kann. Die Unterseite des Elektrizitätszählers hat eine Breite, die sich von der linken Seitenwand bis zu der rechten Seitenwand des Gehäuses erstrecken kann. Zur Unterseite hin ist das Gehäuse teilweise offen, sodass die Anschlussklemmen zugänglich sind. Wird der Elektrizitätszähler ohne die Baugruppe verwendet, ist ein Klemmendeckel erforderlich, der an dem Gehäuse befestigt wird und die Anschlussklemmen abdeckt. Bei Verwendung der erfindungsgemäßen Baugruppe werden die Anschlussklemmen von der Abdeckung der Baugruppe abdeckt, sodass kein gesonderter, herkömmlicher Klemmendeckel benötigt wird.

Das Haltebauteil umfasst zwei Befestigungsabschnitte, mit denen es an dem Elektrizitätszähler befestigt wird. Beispielweise können die Befestigungsabschnitte jeweils mit einem Befestigungspunkt des Gehäuses des Elektrizitätszählers verbunden werden, insbesondere mit einem Befestigungspunkt, der bei Verwendung des Elektrizitätszählers ohne die Baugruppe zur Befestigung eines herkömmlichen Klemmendeckels vorgesehen sind. Die Befestigung der Befestigungsabschnitte an dem Elektrizitätszähler kann zum Beispiel durch eine Verschraubung oder durch eine Rastverbindung erfolgen.

Das Haltebauteil kann einteilig gefertigt sein, zum Beispiel aus Kunststoff im Spritzgießverfahren. Das Haltebauteil kann insgesamt brückenförmig ausgestaltet sein, wobei die Tragschiene einen Abstand zwischen den ein Tragwerk bildenden Befestigungsabschnitten überspannt.

Die Tragschiene des Haltebauteils weist zwei parallel und in einem genormten Abstand (z.B. gemäß DIN EN 60715:2018-07 "Abmessungen von Niederspannungsschaltgeräten - Genormte Tragschienen für die mechanische Befestigung von elektrischen Geräten in Schaltanlagen") voneinander angeordnete Längskanten auf, an denen die Zusatzgeräte befestigt werden können. Hierzu können die Zusatzgeräte zum Beispiel mit einem Hakenabschnitt hinter einer der Längskanten eingehakt und mit einem Schnappmechanismus hinter der anderen Längskante eingeschnappt werden. Diese Art der Montage wird als Hutschienenmontage bezeichnet. Die Tragschiene kann daher auch als Hutschiene bezeichnet werden, auch wenn sie nicht die diesen Begriff prägende "hutförmige" Querschnittsgeometrie aufweist. Eine Vorderseite der Tragschiene kann eben sein.

Wenn das Haltebauteil an dem Elektrizitätszähler befestigt ist, verläuft die Tragschiene in der Breitenrichtung des Elektrizitätszählers. Die Tragschiene ist dann in einem Abstand von den Anschlussklemmen angeordnet, sodass die Anschlussklemmen zugänglich sind. Dies ist von besonderem Vorteil, weil in einem Montageschritt das Haltebauteil an dem Elektrizitätszähler befestigt werden kann und anschließend bei der Montage eines Zusatzgeräts an der Tragschiene die Anschlussklemmen noch zugänglich sind. Dies ist bei vielen bekannten Befestigungslösungen für Zusatzgeräte nicht möglich, insbesondere bei der aus der Druckschrift DE 10 2009 022 645 B4 bekannten Lösung mit einer auf dem Klemmendeckel befestigten Hutschiene.

Zusätzlich zu dem Haltebauteil umfasst die Baugruppe eine Abdeckung, die an dem Haltebauteil und/oder an dem Elektrizitätszähler befestigt wird. Die Abdeckung deckt dann die Tragschiene und die Anschlussklemmen ab. Die Abdeckung schützt somit vor unbefugtem Zugriff und vor einer versehentlichen Berührung spannungsführender Bauteile. Die Abdeckung deckt außerdem ein an der Tragschiene angeordnetes Zusatzgerät mindestens teilweise ab. Dadurch wird auch das Zusatzgerät vor unbefugtem Zugriff geschützt. Ein Teil des Zusatzgeräts kann zugänglich bleiben, beispielsweise ein Display oder eine Schnittstelle des Zusatzgeräts. Diese Elemente können zum Beispiel hinter einer Öffnung in der Abdeckung angeordnet sein.

Ein besonderer Vorteil der Erfindung ist die Anordnung der Tragschiene in der Nähe der Anschlussklemmen. Dadurch ist eine besonders kompakte Anordnung von Zusatzgeräten und etwaigen Verbindungsleitungen zum Anschließen der Zusatzgeräte nahe an dem Elektrizitätszähler möglich.

Außerdem vereinfacht sich die Montage der Zusatzgeräte, weil die Anschlussklemmen bei montiertem Haltebauteil zugänglich bleiben, sodass die Zusatzgeräte einfach angeschlossen werden können. Zudem muss nur eine Abdeckung montiert und gegebenenfalls durch eine Plombe gesichert werden.

Schließlich bietet die besondere Anordnung der Tragschiene in Breitenrichtung des Elektrizitätszählers die Möglichkeit, die gesamte zur Verfügung stehende Breite auszunutzen und so nötigenfalls mehrere Zusatzgeräte unmittelbar am Zähler unterzubringen.

In einer Ausgestaltung ist die Tragschiene unterhalb und vor den Anschlussklemmen angeordnet, sodass zwischen der Tragschiene und den Anschlussklemmen ein vertikaler Abstand und ein horizontaler Abstand besteht, wenn der Elektrizitätszähler mit der Rückseite an einer vertikalen Wand angeordnet ist, die Unterseite nach unten weist und die Reihe der Anschlussklemmen horizontal ausgerichtet ist und wenn das Haltebauteil an dem Elektrizitätszähler befestigt ist. Diese Anordnung der Tragschiene relativ zu den Anschlussklemmen ist ideal, um einen Zugang zu den Anschlussklemmen sowohl von unten als auch von vom zu ermöglichen. Bei vielen Anschlussklemmen ist dies zum Gebrauch erforderlich, insbesondere wenn eine anzuschließende Leitung von unten in die Anschlussklemme eingeführt und von vom z.B. mit einer Klemmschraube fixiert werden muss.

In einer Ausgestaltung liegt der vertikale Abstand im Bereich von 20 mm bis 60 mm, sodass die Anschlussklemmen bei einem an der Tragschiene befestigten Zusatzgerät zugänglich bleiben. Dies gilt für Zusatzgeräte, die nach oben um das betreffende Maß oder weniger über die obere Längskante der Tragschiene überstehen. Der horizontale Abstand kann geringer sein und zum Beispiel im Bereich von 3 mm bis 20 mm liegen. Das Einführen von Leitungen in die Anschlussklemmen von unten ist dann ohne weiteres möglich und die Zusatzgeräte können platzsparend, relativ nah an der Wand, an der der Elektrizitätszähler montiert ist, untergebracht werden.

In einer Ausgestaltung erstreckt sich die Tragschiene über die gesamte Breite des Elektrizitätszählers und die beiden Befestigungsabschnitte sind an gegenüberliegenden Enden der Tragschiene angeordnete Befestigungsbeine. Die Befestigungsbeine können im beschriebenen Installationszustand insbesondere von jeweils einem Ende der Tragschiene aus schräg nach hinten und oben verlaufen. Die Tragschiene kann eine Länge im Bereich von zum Beispiel 120 mm bis 220 mm aufweisen, bevorzugt im Bereich 160 mm bis 170 mm, und damit Platz für Zusatzgeräte mit einer Gesamtbreite von 9 Einheiten ä 18 mm bieten.

In einer Ausgestaltung weist das Haltebauteil zwei Befestigungsarme auf, an denen die Abdeckung befestigt werden kann, insbesondere mittels einer Rastverbindung. Eine Befestigung der Abdeckung am Elektrizitätszähler selbst ist dann nicht erforderlich. Die Montage der Abdeckung gelingt über die Rastverbindung besonders einfach. Zugleich kann die Rastverbindung sehr platzsparend ausgeführt werden, sodass der für die Zusatzgeräte zur Verfügung stehende Raum hinter der Abdeckung optimal ausgenutzt werden kann.

In einer Ausgestaltung deckt die Abdeckung die Befestigungsabschnitte des Haltebauteils ab und/oder ist durch eine Plombe an dem Haltebauteil gesichert. Dadurch wird der Elektrizitätszähler inklusive der Zusatzgeräte vor unbemerkter Manipulation geschützt. Zum Anbringen einer Plombe können ein Befestigungsabschnitt und ein benachbart angeordneter Abschnitt der Abdeckung jeweils eine Durchgangsöffnung aufweisen, durch die ein Plombiermittel, zum Beispiel ein Plombierstift oder ein Plombierdraht, hindurchgeführt wird.

In einer Ausgestaltung weist das Haltebauteil eine Aufnahme für einen Sicherungshalter auf, in den eine Sicherung einsetzbar ist. Die Sicherung kann insbesondere eine Schmelzsicherung sein. Für einige Zusatzgeräte wie zum Beispiel Leistungsschalter ist eine von der Stromversorgung des Elektrizitätszählers unabhängige Stromversorgung erwünscht, um die Messgenauigkeit des Elektrizitätszählers nicht durch hohe Stromaufnahme aus der Versorgung des Elektrizitätszählers zu beeinträchtigen. Dann ist unter Umständen eine gesonderte Absicherung des Zusatzgeräts erforderlich. Das Haltebauteil mit der Aufnahme kann eine zusammenhängende Einheit bilden. Die Aufnahme für den Sicherungshalter kann in das Haltebauteil integriert sein. Die Aufnahme kann relativ zu dem Haltebauteil fest angeordnet sein. Die Aufnahme kann mit dem Haltebauteil verbunden oder einteilig mit dem Haltebauteil gefertigt sein. Die Aufnahme kann sich insbesondere in oder an der Tragschiene des Haltebauteils befinden. Die Integration des Sicherungshalters in das Haltebauteil führt zu einer immer gleichen, übersichtlichen Anordnung der Sicherung, was das Anschließen des Zusatzgeräts über die Sicherung vereinfacht und das Risiko eines Stromschlags reduziert. Außerdem kann das Haltebauteil mit Aufnahme und Sicherungshalter und optional einer Sicherung vormontiert und als fertige Baueinheit vertrieben werden.

In einer Ausgestaltung weist das Haltebauteil zwei Federkontakte auf, die mit den beiden Enden einer Sicherung in Kontakt stehen, wenn die Sicherung in den Sicherungshalter und der Sicherungshalter in die Aufnahme des Haltebauteils eingesetzt ist. Hierzu kann insbesondere eine kleine Leiterplatte, die mit den Federkontakten bestückt ist, in das Haltebauteil integriert oder daran befestigt werden.

In einer Ausgestaltung weist das Haltebauteil Anschlussklemmen, Steckverbinder und/oder vorkonfektionierte Anschlussleitungen auf, die jeweils mit einem der beiden Federkontakte verbunden sind. Insbesondere kann eingangs- und ausgangsseitig jeweils ein Paar von Anschlussklemmen, jeweils ein mindestens zweipoliger Steckverbinder bzw. jeweils ein Paar von vorkonfektionierten Anschlussleitungen vorgesehen sein. Dadurch ist es besonders einfach und risikolos möglich, ein Zusatzgerät anzuschließen. Insbesondere kann das Zusatzgerät über die jeweilige Verbindung auf einer Seite der Sicherung angeschlossen werden, und die jeweilige Verbindung auf der anderen Seite der Sicherung wird mit den Anschlussklemmen des Elektrizitätszählers, über die die Stromversorgung für das Zusatzgeräts erfolgen soll, verbunden. Auf der einen Seite der Sicherung können auch mehrere Paare von Anschlussklemmen, mehrere (zum Beispiel mindestens zweipolige) Steckverbinder und/oder mehrere Paare von vorkonfektionierten Anschlussleitungen vorhanden sein, sodass mehrere Zusatzgeräte angeschlossen werden können.

In einer Ausgestaltung weist die Aufnahme eine Öffnung an einer Vorderseite der Tragschiene auf. Der Sicherungshalter kann in diesem Fall von vorn in die Öffnung eingesetzt werden, insbesondere so, dass er nicht über die Vorderseite der Tragschiene übersteht und die Montage der Zusatzgeräte nicht behindert. Solange im Bereich der Öffnung kein Zusatzgerät montiert ist, kann die Sicherung besonders einfach eingesetzt oder ausgewechselt werden.

In einer Ausgestaltung weist die Aufnahme eine Öffnung an einer Unterseite des Haltebauteils auf, zum Beispiel an einer Unterseite der Tragschiene. In diesem Fall kann der Sicherungshalter sehr einfach von unten in die Öffnung eingesetzt werden. Dies ist bei geeigneter Anordnung der Öffnung sogar bei montierten Zusatzgeräten möglich.

In einer Ausgestaltung ist der Sicherungshalter über ein Gelenk mit dem Haltebauteil verbunden, sodass der Sicherungshalter ausklappbar ist. Der Sicherungshalter ist dann besonders einfach zu handhaben.

In einer Ausgestaltung weist die Aufnahme eine Führung auf, sodass der Sicherungshalter in die Aufnahme einschiebbar ist. Dies erlaubt ebenfalls ein einfaches Einsetzen und Herausziehen des Sicherungshalters.

In einer Ausgestaltung ist der Sicherungshalter unverlierbar mit dem Haltebauteil verbunden. Dies verhindert ein Herunterfallen des Sicherungshalters und trägt dazu bei, dass der Sicherungshalter bzw. die Sicherung nicht versehentlich einen Kurzschluss verursacht.

In einer Ausgestaltung richtet sich die Erfindung auf ein Messsystem mit einem Elektrizitätszähler und einer Baugruppe zur Montage eines Zusatzgeräts an dem Elektrizitätszähler, wobei der Elektrizitätszähler eine Rückseite, eine Vorderseite und mehrere Anschlussklemmen aufweist, die an einer Unterseite des Elektrizitätszählers in einer Reihe entlang einer Breitenrichtung des Elektrizitätszählers angeordnet sind, wobei die Baugruppe folgendes aufweist:
- ein Haltebauteil, das zwei Befestigungsabschnitte, mit denen das Haltebauteil an dem Elektrizitätszähler befestigt ist, und eine Tragschiene aufweist, an der ein Zusatzgerät befestigt werden kann,
- wobei die Tragschiene in der Breitenrichtung des Elektrizitätszählers verläuft und in einem Abstand von den Anschlussklemmen angeordnet ist, sodass die Anschlussklemmen zugänglich sind, und
- eine Abdeckung zur Befestigung an dem Haltebauteil und/oder an dem Elektrizitätszähler, wobei die Abdeckung die Tragschiene und die Anschlussklemmen und mindestens teilweise ein an der Tragschiene angeordnetes Zusatzgerät abdeckt, wenn die Abdeckung an dem Haltebauteil und/oder an dem Elektrizitätszähler befestigt ist.

Das Messsystem entspricht dem bestimmungsgemäßen Einsatz der Baugruppe in Verbindung mit einem Elektrizitätszähler. Die obigen Erläuterungen der Merkmale und Vorteile von Elektrizitätszähler und Baugruppe gelten daher entsprechend für das Messsystem. Das Messsystem kann zusätzlich mindestens ein Zusatzgerät aufweisen, dass an der Tragschiene befestigt ist. Das Messsystem kann insbesondere gemäß einer Ausgestaltung oder gemäß mehreren Ausgestaltungen ausgebildet sein, die vorstehend zu der Baugruppe erläutert worden sind.

Nachfolgend wird die Erfindung anhand von in Figuren dargestellten Ausführungsbeispielen näher erläutert. Es zeigen:
- Fig. 1: einen Elektrizitätszähler in einer perspektivischen Darstellung,
- Fig. 2: den Elektrizitätszähler aus Fig. 1 mit montiertem Haltebauteil in einer perspektivischen Darstellung,
- Fig. 3: die Anordnung aus Fig. 2 mit montierten Zusatzgeräten in einer perspektivischen Darstellung,
- Fig. 4: die Anordnung aus Fig. 3 mit montierter Abdeckung in einer perspektivischen Darstellung,
- Fig. 5: die Anordnung aus Fig. 2 in einer anderen perspektivischen Darstellung mit herausgezogenem Sicherungshalter,
- Fig. 6: eine Leiterplatte mit Sicherungshalter in einer perspektivischen Darstellung,
- Fig. 7: das Haltebauteil und die Abdeckung aus Fig. 4 in einer perspektivischen, teilweise geschnittenen Darstellung,
- Fig. 8: ein Haltebauteil mit einem Sicherungshalter in einer perspektivischen Darstellung,
- Fig. 9: das Haltebauteil aus Fig. 8 mit ausgeklapptem Sicherungshalter in einer perspektivischen Darstellung.

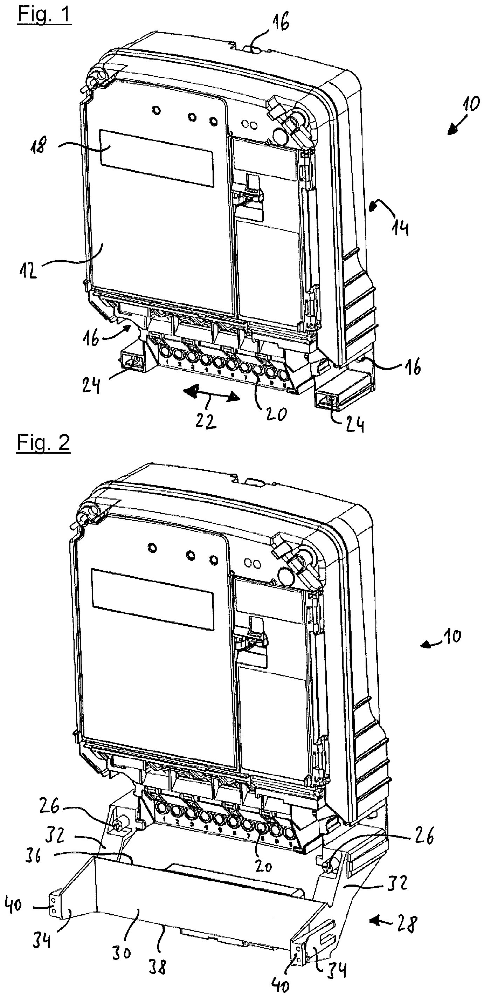

Der Elektrizitätszähler 10 aus Fig. 1 hat eine dem Betrachter zugewandte Vorderseite 12 und eine Rückseite 14, die an einer nicht dargestellten Wand zum Beispiel in einem Zählerschrank montiert wird. Hierzu weist der Zähler drei Befestigungsöffnungen 16 auf, die in Fig. 1 nur teilweise erkennbar sind. An der Vorderseite 12 ist ein Display 18 angeordnet.

An der Unterseite des Elektrizitätszählers 10 sind mehrere Anschlussklemmen 20 in einer Reihe angeordnet, entlang einer Breitenrichtung 22 des Elektrizitätszählers 10. Zu beiden Seiten der Anschlussklemmen 20 weist der Elektrizitätszähler 10 jeweils einen Befestigungspunkt 24 auf, in den eine Befestigungsschraube 26 (siehe Fig. 2) eingesetzt werden kann. Wird der Elektrizitätszähler 10 ohne erfindungsgemäße Baugruppe verwendet, kann mit diesen Befestigungsschrauben 26 ein herkömmlicher Klemmendeckel befestigt werden, der die Anschlussklemmen 20 abdeckt.

In Fig. 2 ist zusätzlich zu dem Elektrizitätszähler 10 ein Haltebauteil 28 gezeigt, das eine Tragschiene 30, zwei Befestigungsbeine 32 und zwei Befestigungsarme 34 aufweist. Die Tragschiene 30 ist horizontal ausgerichtet und erstreckt sich über die gesamte Breite des Elektrizitätszählers 10. Die Tragschiene 30 weist zwei parallel und in genormtem Abstand voneinander angeordnete Längskanten auf, nämlich eine obere Längskante 36 und eine untere Längskante 38. Eine dem Betrachter zugewandte Vorderseite der Tragschiene 30 erstreckt sich von der unteren Längskante 38 bis zu der oberen Längskante 36 und ist flach ausgebildet.

Die beiden Befestigungsbeine 32 verlaufen jeweils von einem Ende der Tragschiene 30 aus schräg nach oben und hinten bis zu einem der beiden Befestigungspunkte 24, wo sie mit jeweils einer Befestigungsschraube 26 befestigt sind. Die Tragschiene 30 befindet sich dadurch in einem vertikalen Abstand und in einem horizontalen Abstand von den Anschlussklemmen 20, sodass die Anschlussklemmen 20 bei montiertem Haltebauteil 28 sowohl von vorn aus als auch von unten aus zugänglich sind.

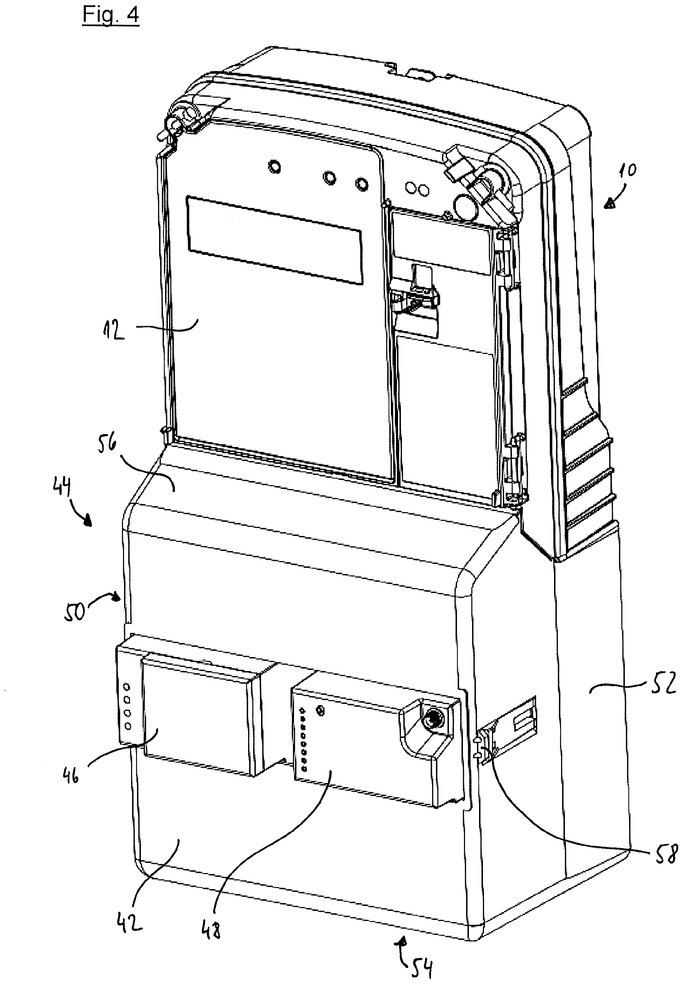

Die beiden Befestigungsarme 34 beginnen ebenfalls jeweils an einem Ende der Tragschiene 30 und verlaufen von dort aus etwa horizontal nach vorn. Sie weisen jeweils ein freies Ende 40 in einem Abstand von der Vorderseite der Tragschiene 30 auf, an dem eine Vorderwand 42 der Abdeckung 44 (siehe Fig. 4) anliegt.

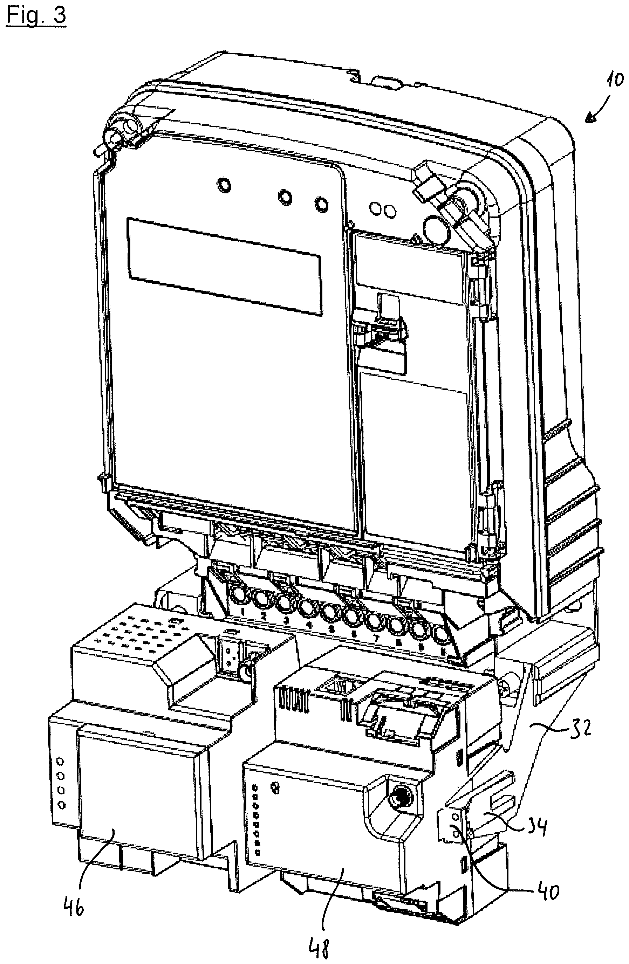

In Fig. 3 sind an der Tragschiene 30 zwei Zusatzgeräte montiert, nämlich links ein Smart Meter Gateway 46 und rechts eine Schalteinrichtung 48. Beide haben eine Breite von jeweils vier Einheiten ä 18 mm. Die Länge der Tragschiene 30 ist ausreichend, um beide Zusatzgeräte 46, 48 daran zu befestigen. Zwischen den beiden Zusatzgeräten 46, 48 bleibt sogar noch eine Einheit à 18 mm frei, die zum Beispiel zur Aufnahme einer Antenne genutzt werden könnte.

Man erkennt, dass die beiden Zusatzgeräte 46, 48 sehr nahe am Elektrizitätszähler 10 angeordnet sind, sodass sich ein kompakter Aufbau ergibt. Dennoch bleiben die Anschlussklemmen 20 weiterhin von unten und von vom zugänglich, und unterhalb der Tragschiene 30 bleibt ausreichend Freiraum zur Anordnung von Verbindungsleitungen zum Anschließen der Zusatzgeräte 46, 48.

In Fig. 4 ist das Messsystem durch eine Abdeckung 44 komplettiert, die an dem Haltebauteil 28 befestigt ist. Die Abdeckung 44 weist eine Vorderwand 42, eine linke Seitenwand 50 (vom Betrachter abgewandt), eine rechte Seitenwand 52, eine untere Wand 54 (vom Betrachter abgewandt) und eine schräg angeordnete, kürzere obere Wand 56 auf, die an der Vorderseite 12 des Elektrizitätszählers 10 endet. Die beiden Zusatzgeräte 46, 48 sind durch jeweils eine Öffnung in der Abdeckung 44 hindurch zum Teil zugänglich. Die übrigen Teile der Zusatzgeräte 46, 48 sind von der Abdeckung 44 abgedeckt, ebenso das gesamte Haltebauteil 28 und die Anschlussklemmen 20.

An der Vorderwand 42 der Abdeckung 44 stehen seitlich zwei Stege 58 vor (nur der Steg an der rechten Seite ist sichtbar), die jeweils zwei kleine Durchgangsöffnungen aufweisen. Diese Stege 58 liegen an den freien Enden 40 der Befestigungsarme 34 an. Die freien Enden 40 der Befestigungsarme 34 weisen ebenfalls jeweils zwei kleine Durchgangsöffnungen auf, die deckungsgleich zu den Durchgangsöffnungen der Stege 58 angeordnet sind, sodass auf beiden Seiten der Abdeckung 44 ein Plombierdraht in die jeweiligen Durchgangsöffnungen eingesetzt werden kann.

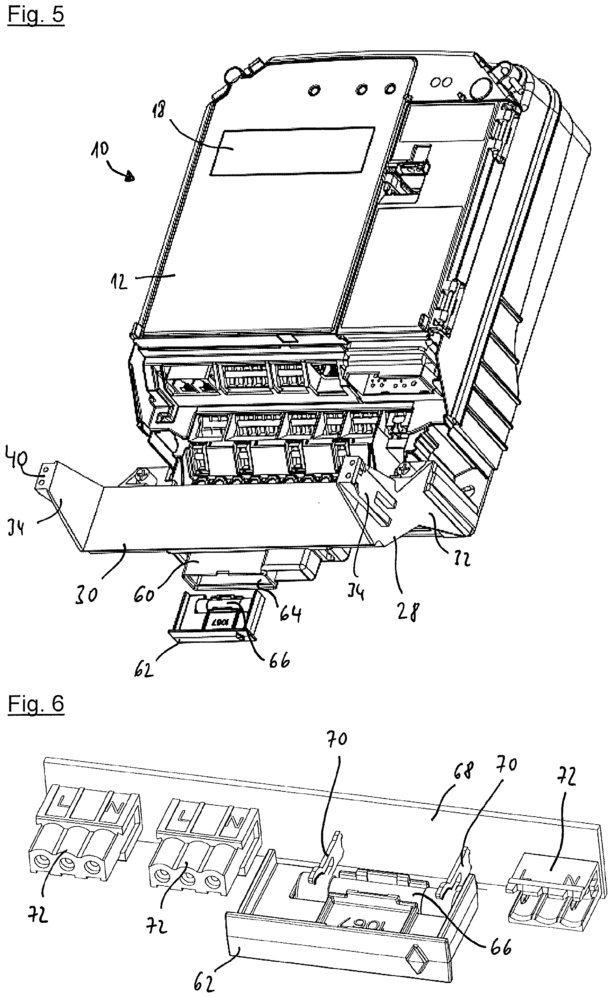

Figur 5 zeigt den Elektrizitätszähler 10 mit montiertem Haltebauteil 28 in einer etwas anderen Perspektive als Fig. 2. Man erkennt, dass an der Rückseite der Tragschiene 30 eine Aufnahme 60 für einen Sicherungshalter 62 vorhanden ist, die eine nach unten weisende Öffnung 64 hat. Durch diese Öffnung 64 hindurch kann der Sicherungshalter 62 in die Aufnahme 60 eingesetzt werden. Ebenfalls erkennbar ist der Sicherungshalter 62 selbst mit einer eingesetzten Sicherung 66.

Die in Fig. 6 gezeigte Leierplatte 68 befindet sich innerhalb der Aufnahme 60 und ist somit in das Haltebauteil 28 integriert. Die Leiterplatte 68 ist mit zwei Federkontakten 70 bestückt, die an den endseitigen Kontakten der Sicherung 66 anliegen, wenn der Sicherungshalter 62 mit Sicherung 66 wie in Fig. 6 gezeigt angeordnet ist, entsprechend einer in die Aufnahme 60 eingesetzten Stellung des Sicherungshalters 62.

In Fig. 6 auf der rechten Seite befindet sich ein zweipoliger Steckverbinder 72, über den die Leiterplatte 68 an zwei Anschlussklemmen 20 des Elektrizitätszählers 10 angeschlossen wird, um eine Stromversorgung für die Zusatzgeräte 46, 48 bereitzustellen. Auf der anderen Seite der Sicherung 66 weist die Leiterplatte 68 zwei weitere Steckverbinder 72 auf (ebenfalls mit jeweils zwei angeschlossenen Kontakten, bezeichnet mit L und N), die über ein Kabel jeweils mit einem Zusatzgeräte 46, 48 verbunden werden können. Auf diese Weise können zwei Zusatzgeräte 46, 48 über die Sicherung 66 an die Stromversorgung angeschlossen werden.

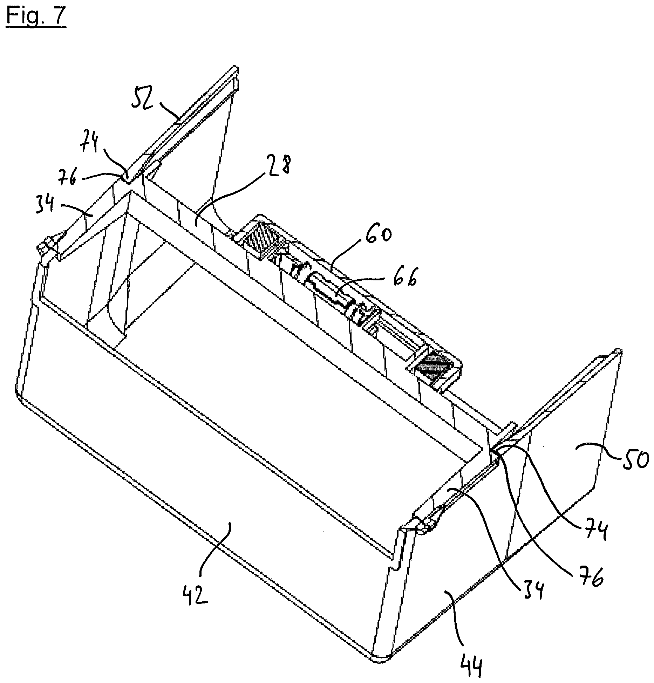

Figur 7 zeigt das Haltebauteil 28 und die Abdeckung 44 im Schnitt. Man erkennt, dass an der Innenseite der Seitenwände 50, 52 der Abdeckung 64 Rastvorsprünge 74 ausgebildet sind, die jeweils in eine Aussparung 76 am Haltebauteil 28 einrasten und so die Abdeckung 44 am Haltebauteil 28 fixieren. Diese Aussparungen 76 am Haltebauteil 28 befinden sich an den Außenseiten der Befestigungsarme 34. An der Rückseite der Tragschiene 30 sind außerdem die Aufnahme 60 für den Sicherungshalter 62 und andeutungsweise eine darin angeordnete Sicherung 66 erkennbar.

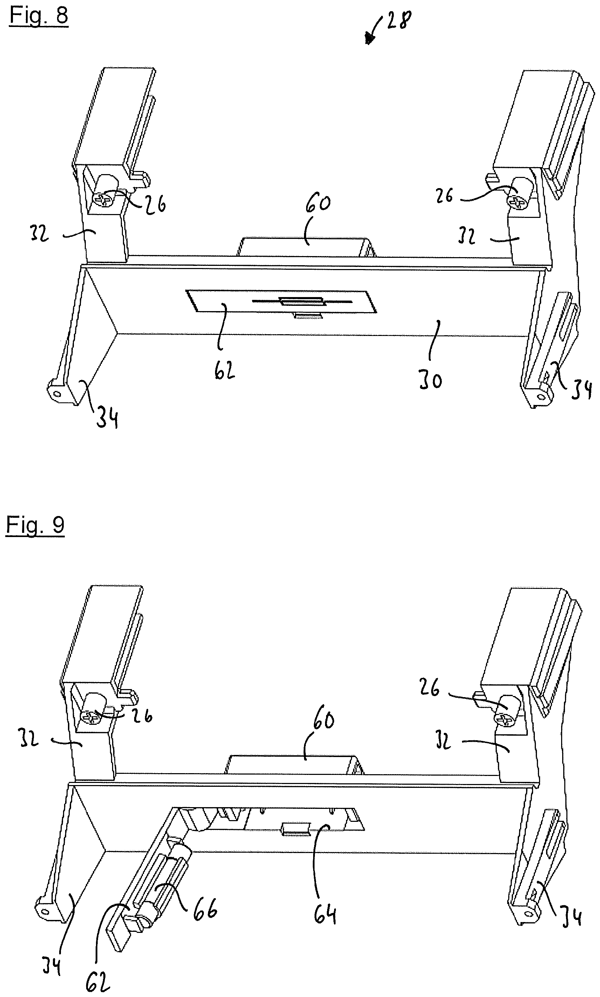

Die Figuren 8 und 9 zeigen ein anderes Haltebauteil 28, dass ähnlich wie das Haltebauteil 28 aus Fig. 2 eine Tragschiene 30, zwei Befestigungsbeine 32 und zwei Befestigungsarme 34 aufweist. Es gibt auch an der Rückseite der Tragschiene 30 eine Aufnahme 60 für einen Sicherungshalter 62. Dieser ist über ein Gelenk ausklappbar mit der Tragschiene 30 verbunden. In der eingeklappten Stellung (Fig. 8) ist der Sicherungshalter 62 in eine Öffnung 64 in der Vorderseite der Tragschiene 30 eingesetzt und schließt bündig mit der Vorderseite der Tragschiene 30 ab. In der ausgeklappten Stellung (Fig. 9) kann die Sicherung 66 entnommen und eingesetzt werden.

### Liste der Bezugszeichen

- 10: Elektrizitätszähler
- 12: Vorderseite
- 14: Rückseite
- 16: Befestigungsöffnungen
- 18: Display
- 20: Anschlussklemmen
- 22: Breitenrichtung
- 24: Befestigungspunkt
- 26: Befestigungsschraube
- 28: Haltebauteil
- 30: Tragschiene
- 32: Befestigungsbeine
- 34: Befestigungsarme
- 36: obere Längskante
- 38: untere Längskante
- 40: freies Ende
- 42: Vorderwand
- 44: Abdeckung
- 46: Smart Meter Gateway
- 48: Schalteinrichtung
- 50: linke Seitenwand
- 52: rechte Seitenwand
- 54: untere Wand
- 56: obere Wand 56
- 58: Steg
- 60: Aufnahme
- 62: Sicherungshalter
- 64: Öffnung
- 66: Sicherung
- 68: Leierplatte
- 70: Federkontakt
- 72: Steckverbinder
- 74: Rastvorsprung
- 76: Aussparung

## Patentansprüche

1. Baugruppe zur Montage eines Zusatzgeräts (46, 48) an einem Elektrizitätszähler (10), wobei der Elektrizitätszähler (10) eine Rückseite (14), eine Vorderseite (12) und mehrere Anschlussklemmen (20) aufweist, die an einer Unterseite des Elektrizitätszählers (10) in einer Reihe entlang einer Breitenrichtung (22) des Elektrizitätszählers (10) angeordnet sind, wobei die Baugruppe folgendes aufweist:
• ein Haltebauteil (28), das zwei Befestigungsabschnitte zur Befestigung an dem Elektrizitätszähler (10) und eine Tragschiene (30) aufweist, an der ein Zusatzgerät (46, 48) befestigt werden kann,
• wobei, wenn das Haltebauteil (28) an dem Elektrizitätszähler (10) befestigt ist, die Tragschiene (30) in der Breitenrichtung (22) des Elektrizitätszählers (10) verläuft und in einem Abstand von den Anschlussklemmen (20) angeordnet ist, sodass die Anschlussklemmen (20) zugänglich sind, und
• eine Abdeckung (44) zur Befestigung an dem Haltebauteil (28) und/oder an dem Elektrizitätszähler (10), wobei die Abdeckung (44) die Tragschiene (30) und die Anschlussklemmen (20) und mindestens teilweise ein an der Tragschiene (30) angeordnetes Zusatzgerät (46, 48) abdeckt, wenn die Abdeckung (44) an dem Haltebauteil (28) und/oder an dem Elektrizitätszähler (10) befestigt ist.

2. Baugruppe nach Anspruch 1, wobei die Tragschiene (30) unterhalb und vor den Anschlussklemmen (20) angeordnet ist, sodass zwischen der Tragschiene (30) und den Anschlussklemmen (20) ein vertikaler Abstand und ein horizontaler Abstand besteht, wenn der Elektrizitätszähler (10) mit der Rückseite (14) an einer vertikalen Wand angeordnet ist, die Unterseite nach unten weist und die Reihe der Anschlussklemmen (20) horizontal ausgerichtet ist und wenn das Haltebauteil (28) an dem Elektrizitätszähler (10) befestigt ist.

3. Baugruppe nach Anspruch 1 oder 2, wobei der vertikale Abstand im Bereich von 20 mm bis 60 mm liegt, sodass die Anschlussklemmen (20) bei einem an der Tragschiene (30) befestigten Zusatzgerät (46, 48) zugänglich bleiben.

4. Baugruppe nach einem der Ansprüche 1 bis 3, wobei sich die Tragschiene (30) über die gesamte Breite des Elektrizitätszählers (10) erstreckt und die beiden Befestigungsabschnitte an gegenüberliegenden Enden der Tragschiene (30) angeordnete Befestigungsbeine (32) sind.

5. Baugruppe nach einem der Ansprüche 1 bis 4, wobei das Haltebauteil (28) zwei Befestigungsarme (34) aufweist, an denen die Abdeckung (44) befestigt werden kann, insbesondere mittels einer Rastverbindung.

6. Baugruppe nach einem der Ansprüche 1 bis 5, wobei die Abdeckung (44) die Befestigungsabschnitte des Haltebauteils (28) abdeckt und/oder durch eine Plombe an dem Haltebauteil (28) gesichert ist.

7. Baugruppe nach einem der Ansprüche 1 bis 6, wobei das Haltebauteil (28) eine Aufnahme (60) für einen Sicherungshalter (62) aufweist, in den eine Sicherung (66) einsetzbar ist.

8. Baugruppe nach Anspruch 7, wobei das Haltebauteil (28) zwei Federkontakte (70) aufweist, die mit den beiden Enden einer Sicherung (66) in Kontakt stehen, wenn die Sicherung (66) in den Sicherungshalter (62) und der Sicherungshalter (62) in die Aufnahme (60) des Haltebauteils (28) eingesetzt ist.

9. Baugruppe nach Anspruch 7 oder 8, wobei das Haltebauteil (28) Anschlussklemmen, Steckverbinder (72) und/oder vorkonfektionierte Anschlussleitungen aufweist, die jeweils mit einem der beiden Federkontakte (70) verbunden sind.

10. Baugruppe nach einem der Ansprüche 7 bis 9, wobei die Aufnahme (60) eine Öffnung (64) an einer Vorderseite der Tragschiene (30) aufweist.

11. Baugruppe nach einem der Ansprüche 7 bis 10, wobei die Aufnahme (60) eine Öffnung (64) an einer Unterseite des Haltebauteils (28) aufweist.

12. Baugruppe nach einem der Ansprüche 7 bis 11, wobei der Sicherungshalter (62) über ein Gelenk mit dem Haltebauteil (28) verbunden ist, sodass der Sicherungshalter (62) ausklappbar ist.

13. Baugruppe nach einem der Ansprüche 7 bis 11, wobei die Aufnahme (60) eine Führung aufweist, sodass der Sicherungshalter (62) in die Aufnahme (60) einschiebbar ist.

14. Baugruppe nach einem der Ansprüche 7 bis 13, wobei der Sicherungshalter (62) unverlierbar mit dem Haltebauteil (28) verbunden ist.

15. Messsystem mit einem Elektrizitätszähler (10) und einer Baugruppe zur Montage eines Zusatzgeräts (46, 48) an dem Elektrizitätszähler (10), wobei der Elektrizitätszähler (10) eine Rückseite (14), eine Vorderseite (12) und mehrere Anschlussklemmen (20) aufweist, die an einer Unterseite des Elektrizitätszählers (10) in einer Reihe entlang einer Breitenrichtung (22) des Elektrizitätszählers (10) angeordnet sind, wobei die Baugruppe folgendes aufweist:
• ein Haltebauteil (28), das zwei Befestigungsabschnitte, mit denen das Haltebauteil (28) an dem Elektrizitätszähler (10) befestigt ist, und eine Tragschiene (30) aufweist, an der ein Zusatzgerät (46, 48) befestigt werden kann,
• wobei die Tragschiene (30) in der Breitenrichtung (22) des Elektrizitätszählers (10) verläuft und in einem Abstand von den Anschlussklemmen (20) angeordnet ist, sodass die Anschlussklemmen (20) zugänglich sind, und
• eine Abdeckung (44) zur Befestigung an dem Haltebauteil (28) und/oder an dem Elektrizitätszähler (10), wobei die Abdeckung (44) die Tragschiene (30) und die Anschlussklemmen (20) und mindestens teilweise ein an der Tragschiene (30) angeordnetes Zusatzgerät (46, 48) abdeckt, wenn die Abdeckung (44) an dem Haltebauteil (28) und/oder an dem Elektrizitätszähler (10) befestigt ist.
